# EUROPÄISCHE PATENTSCHRIFT

(11) **EP 0 418 733 B1**
(45) Veröffentlichungstag und Bekanntmachung des Hinweises auf die Patenterteilung: **14.01.1998**
(21) Anmeldenummer: 90117636.2
(22) Anmeldetag: 13.09.1990
(51) Int. Cl.: G03F 7/032, C08G 59/40, C08F 257/02, C08F 283/10

(54) **Durch Strahlung polymerisierbares Gemisch und Verfahren zur Herstellung einer Lötstopmaske**
Radiation-curable composition and method of producing a solder mask
Mélange polymérisable par radiation et procédé de préparation d'un masque pour soudage

(30) Priorität: 21.09.1989 DE 3931467
(43) Veröffentlichungstag der Anmeldung: 27.03.1991
(73) Patentinhaber: Morton International, Inc., Chicago, Illinois 60606-1596 (US)
(72) Erfinder: Emmelius, Michael, Dr., W-6500 Mainz-Bretzenheim (DE); Herwig, Walter, Dr., D-6232 Bad Soden/Taunus (DE); Erbes, Kurt, D-6093 Flörsheim 3 (DE); Decker, Rudolf, D-6501 Bodenheim (DE)
(74) Vertreter: Weber, Dieter, Dr.

(56) Entgegenhaltungen:
- EP-A- 0 063 304
- EP-A- 0 283 990
- WO-A-89/05476
- GB-A- 2 119 810

## Beschreibung

Die Erfindung betrifft ein durch Strahlung polymerisierbares Gemisch, das zur Herstellung von Lötstopmasken verwendet wird.

Es ist bekannt, Lötstopmasken auf Leiterplatten nach der Photoresisttechnik herzustellen. Ebenso wie bei der Herstellung gedruckter Schaltungen werden hier Photoresistlösungen auf die strukturierte Leiterplatte aufgebracht, getrocknet und bildmäßig an den Stellen durch Belichten gehärtet, an denen die Leiterplatte abgedeckt werden soll. Durch Auswaschen der unbelichteten Schichtstellen erhält man die Lötstopmaske. Die Photoresistschicht kann auch nach dem Trockenresistverfahren durch Laminieren einer vorgefertigten thermoplastischen Schicht auf die Leiterplatte aufgebracht werden.

Leiterplatten mit ein- und doppelseitigem, vor allem aber durchkontaktiertem Aufbau, werden mit Lötstopmasken versehen, bevor sie Lötprozessen zugeführt werden. Heute unterscheidet man zwei wichtige Arten des maschinellen Lötens:
1. Heißverzinnungsprozeß (Hot Air Levelling-Verfahren). Bei diesem Prozeß werden nicht bestückte, durchkontaktierte, in reiner Kupferschaltung hergestellte Leiterplatten mit einer Lötstopmaske so präpariert, daß die verkupferten Bohrlöcher frei bleiben oder freigelegt werden. Diese Platinen werden in flüssiges Lot getaucht, die freien Kupferelemente dabei mit dem Lot festhaftend belegt und anschließend im noch heißen Zustand in den Lochbereichen durch heiße Preßluft freigeblasen.
2. Wellen- oder Schwall-Löten. Dabei wird das Löten von mit Bauteilen bestückten Leiterplatten durch maschinelles Führen über flüssige Lotoberflächen durchgeführt.

Da sich neuerdings reine Kupfertechniken immer mehr durchsetzen und zusätzlich durchkontaktierte Schaltungen in breitem Maße Verwendung finden, haben fertig bestückte und voll funktionsfähige Leiterplatten häufig zwei Lötprozesse, nämlich die unter 1 und 2 beschriebenen, hinter sich. Zwei Lötungen stellen naturgemäß hohe Anforderungen an die thermische Resistenz einer Lötstopmaske. Diese Anforderungen lassen sich um so schwerer erfüllen, je mehr andere wichtige Eigenschaften gefordert werden.

Für die Herstellung von Lötstopmasken geeignete Materialien sind z. B. in der DE-A 27 47 947 beschrieben. Es handelt sich hierbei um photopolymerisierbare Schichten, die zur Verbesserung der Flammwidrigkeit eine bestimmte Menge gebundenes Halogen enthalten. Ein ähnliches Material ist in der EP-A 15 004 beschrieben, das sich trocken durch mechanisches Trennen von belichteten und unbelichteten Schichtbereichen entwickeln läßt ("peel-apart-Verfahren"). Schließlich wird in der EP-A 2040 ein für den gleichen Zweck bestimmtes lichthärtbares Material beschrieben, bei dem als lichtempfindliche Verbindungen bestimmte Epoxyharze verwendet werden.

In der EP-B 0 113 409 wird eine lichtempfindliche Schicht über eine Siebdruckschablone aufgebracht, die Photopolymerisation dient also nur zur Maskenhärtung und wird nicht zur Bilderzeugung genutzt.

Die GB-A-2119810 beschreibt eine durch Strahlung und Hitze aktivierbare Zusammensetzung aus einem thermoplastischen Polymer, einem Weichmacher für das thermoplastische Polymer, einem Photoinitiator und einem durch Hitze aktivierbaren Initiator, wobei das thermoplastische Polymer eine flüssige, ethylenisch ungesättigte Komponente und ein Epoxidharz enthält. Der durch Hitze aktivierbare Initiator ist ein BF₃-Addukt. Eine aus dieser Zusammensetzung hergestellte Beschichtung wird zuerst mit UV-Licht bestrahlt und anschließend durch Erhitzen für 20 bis 30 Minuten auf 120 bis 140 °C gehärtet.

In der EP-A-0283990 wird eine hitzebeständige, photosensitive Harzzusammensetzung für Lötstopmasken beschrieben, die im wesentlichen ein Copolymer aus N-Alkoxyalkyl-(meth) acrylamid und einer ethylenisch ungesättigten Komponente, nämlich Acrylsäure oder Methacrylsäure, ein photopolymerisierbares Monomer, einen Photopolymerationsinitiator, einen pulverförmigen Feststoff und ein Bindemittel enthält. Die erhaltene Lötstopmaske läßt sich mit einer wäßrig alkalischen Lösung entwickeln und ist beständig gegen Hitze und verschiedene Chemikalien.

Die WO-A-89/05476 beschreibt eine photopolymerisierbare Zusammensetzung für Lötmasken mit einem in wäßriger oder alkalisch wäßriger Lösung löslichen polymeren Bindemittel, bestehend aus Acrylsäuren und Acrylsäurenestern, einem Vernetzungsreagenz, einem photosensitiven Initiatorsystem, einem Epoxidharz und einem Bindemittel für das Epoxidharz. Eine aus dieser Zusammensetzung hergestellte Lötmaske wird nach Belichtung mit aktinischer Strahlung in wäßriger Lösung entwickelt und anschließend durch Hitze gehärtet.

In der US-A 3 776 729 wird eine hauptsächlich aus photopolymerisierbaren Acrylaten und thermisch vernetzbaren Epoxiden bestehende Mischung beschrieben. Eine aus dieser Mischung hergestellte Maske wird nach bildmäßiger UV-Belichtung in organischen Lösemitteln (z. B. Butanon) entwickelt und durch Erhitzen gehärtet.

Die EP-A 0 273 729 beschreibt ein lichtempfindliches, wäßrig-alkalisch entwickelbares Gemisch für Lötstopmasken, das im wesentlichen hergestellt wird durch Umsetzung von epoxydierten Phenolharzen mit Acrylsäure und Maleinsäureanhydrid. Das Umsetzungsprodukt enthält keine Epoxygruppen mehr.

Gemäß der EP-A 0 280 295 wird die wäßrig-alkalische Entwickelbarkeit einer belichteten Maske durch Copolymerisate erzielt, die N-Isobutoxymethyl-acrylamid und Methacrylsäure als Cokomponenten enthalten. Die erhaltene Lötmaske läßt sich thermisch nachhärten, erfordert aber relativ lange Härtungszeiten bei relativ hohen Temperaturen.

Gemäß der DE-A 31 14 931 wird dem photopolymerisierbaren Gemisch für die Herstellung der Lötstopmaske eine Bis-Epoxyverbindung zugesetzt und die lichtgehärtete Bildschablone nach dem Entwickeln durch Erhitzen nachgehärtet. Nach diesem Verfahren werden sehr temperaturbeständige Lötstopmasken erhalten. Das Gemisch enthält jedoch kein anorganisches Pigment.

In der EP-A 73 444 werden ähnliche Gemische beschrieben, die im unbelichteten Zustand eine gute Lagerfähigkeit aufweisen. Die Gemische enthalten Verbindungen, die mit dem Bindemittel, dem Polymerisationsprodukt der ethylenisch ungesättigten Verbindung und/oder mit sich selbst thermisch vernetzbar sind. Bevorzugt werden solche Verbindungen eingesetzt, die als vernetzende Gruppen Epoxygruppen oder Gruppen der Formel -CH₂-O-R enthalten, worin R ein Wasserstoffatom, eine niedere Alkyl-, Acyl- oder Hydroxyalkylgruppe ist und in denen die Gruppen -CH₂OR an einem Stickstoffatom eines niedermolekularen offenkettigen oder cyclischen Säureamids oder an einem aromatischen Kohlenstoffatom einer zur Kondensation mit Formaldehyd befähigten Verbindung stehen.

Die in dieser Druckschrift beschriebenen Gemische weisen jedoch noch zwei entscheidende Nachteile auf. Zum einen kommt es unter bestimmten Lötbedingungen vor, daß - vermutlich infolge Erweichung der Schicht - nach dem Schwall-Löten Fäden oder Kügelchen der Lötlegierung an der Oberfläche der Lötstopmaske haften bleiben, was unter Umständen zu Kurzschlüssen führen kann.

Das Auftreten dieser sogenannten "Zinnspinnweben" kann - wie in der DE-A 32 36 560 beschrieben - durch Aufrauhung der Photopolymerschicht mittels einer pigmentierten Polyesterfolie vermindert werden. Es kann jedoch hierdurch nicht vollkommen ausgeschlossen werden. Weiterhin weisen die Gemische der EP-A 73 444 im ausgehärteten Zustand eine unzureichende Lösemittelresistenz auf. Beim Reinigen der gelöteten Leiterplatten kann es zum Erweichen der Lötstopmasken kommen. Außerdem wird bei längeren Einwirkzeiten von Lösemitteln, z. B. Ethanol, der in der Schicht enthaltene Farbstoff teilweise aus der Schicht herausgelöst.

Aufgabe der Erfindung war es, zur Herstellung von thermisch nachhärtbaren Lötstopmasken geeignete photopolymerisierbare Gemische vorzuschlagen, die sich in Form einer Lösung bzw. Dispersion auf die Unterlagen aufbringen lassen, die einen hohen Feststoffgehalt aufweisen, die bei allen üblichen Beschichtungsverfahren einen guten Verlauf zeigen, die ein gutes Trocknungsverhalten, eine hohe Lichtempfindlichkeit, eine hohe Auflösung und ein gutes Lötverhalten aufweisen die in rein wäßrigen, alkalischen Medien entwickelt werden können und Lötmasken mit guten mechnischen, chemischen und elektrischen Eigenschaften ergeben.

Erfindungsgemäß wird ein durch Strahlung polymerisierbares Gemisch vorgeschlagen, das
a) eine Verbindung mit mindestens zwei endständigen ethylenisch ungesättigten Gruppen, die durch radikalisch initiierte Additionskettenpolymerisation ein vernetztes Polymerisat zu bilden vermag.
b) ein polymeres Bindemittel, das aus Einheiten
   1. von Methacrylsäure,
   2. eines Methacrylsäureesters,
   3. eines Styrols, bestehend aus Styrol, o-, m- oder p-Vinyltoluol, einem Vinylethylbenzol, einem α-Methylstyrol, einem A-Chlorstyrol, einem o-, m- oder p-Chlorstyrol oder einem Vinylanisol, und
   4. ggf. eines Monomers, bestehend aus Acrylsäure, einem Acrylsäureester, Acrylnitril, Methacrylnitril, Acrylamid, Methacrylamid oder einer heterozyklischen Vinylverbindung,
      besteht, wobei
      das Styrol in einer Menge von 40 - 65 Gew.% und der Methacrylsäureester in einer Menge von 5 - 40 Gew.%, bezogen auf das Gewicht des polymeren Bindemittels, und die Methacrylsäure in solcher Menge enthalten ist, daß das polymere Bindemittel eine Säurezahl von 110 - 280 besitzt.
c) 20 - 50% feinteiliges mineralisches Pigment auf Silikat- bzw. Kieselsäurebasis,
d) 0,1 - 15% eines durch Stahlung aktivierbaren Polymerisationsinitiators,
e) 10 - 30% einer Verbindung mit mindestens zwei Epoxygruppen im Molekül und
f) 0,2 - 1,0% eines durch Wärme aktivierbaren Polyadditionsinitiators für Epoxygruppen,
enthält, wobei sich die Prozentzahlen der Bestandteile b), c), d), e) und f) auf den Gesamtgehalt an nicht flüchtigen Bestandteilen in dem Gemisch beziehen.

Erfindungsgemäß wird weiterhin ein Verfahren zur Herstellung einer Lötstopmaske vorgeschlagen, das dadurch gekennzeichnet ist, daß man eine Lösung bzw. Dispersion eines Gemischs der vorstehend angegebenen Zusammensetzung auf die Oberfläche einer gedruckten Schaltung aufbringt und trocknet, die erhaltene Schicht bildmäßig mit aktinischer Strahlung unter Aussparung der Lötaugen bestrahlt, die unbestrahlten Schichtbereiche mit einem Entwickler auswäscht und die erhaltene Lötmaske auf erhöhte Temperatur erwärmt.

Als polymerisierbare Verbindungen werden im allgemeinen Ester der Acryl- oder Methacrylsäure mit mehrwertigen, vorzugsweise primären, Alkoholen verwendet. Der Alkohol sollte mindestens zwei Hydroxygruppen enthalten, da durch mehrfach ungesättigte Verbindungen die erwünschte Vernetzungswirkung erreicht wird. In untergeordneter Menge können auch Ester von einwertigen Alkoholen im Gemisch enthalten sein. Beispiele für geeignete mehrwertige Alkohole sind Ethylenglykol, Propylenglykol, Butandiol-1,4, Diethylenglykol, Triethylenglykol, Oligopropylenglykole, Trimethylolethan und -propan, Pentaerythrit, Dipentaerythrit, Bisphenol-A-bis-hydroxyethylether. Es sind ferner die niedermolekularen, Urethangruppen enthaltenden Bis-acrylate und Bismethacrylate geeignet, die durch Umsetzen von 2 mol Hydroxyalkylacrylat oder -methacrylat mit 1 mol eines aliphatischen oder cycloaliphatischen Diisocyanats, z. B. 2,2,4-Trimethyl-hexamethylendiisocyanat, erhalten werden. Derartige Urethangruppen enthaltende Monomere sind in der US-A 4 088 498 beschrieben. Besonders vorteilhaft sind Acrylate und Methacrylate, insbesondere Acrylate, mit hohem Doppelbindungsgehalt. So werden Monomere mit 3 oder mehr ungesättigten Gruppen bevorzugt. Auch sind im allgemeinen Ester, die noch mindestens eine freie Hydroxygruppe enthalten, den vollständig veresterten Verbindungen überlegen. Die Ester des Trimethylolpropans, Trimethylolethans, des Pentaerythrits und Dipentaerythrits werden besonders bevorzugt. Das Monomere ist im allgemeinen in einer Menge von 10 bis 35, vorzugsweise von 15 bis 30 Gew.-%, bezogen auf den Gesamtgehalt an nichtflüchtigen Bestandteilen, in dem Gemisch enthalten.

Wesentlich für die Brauchbarkeit des erfindungsgemäßen Gemischs ist das polymere Bindemittel. Es besteht normalerweise aus drei Komponenten: Methacrylsäure, einem Methacrylsäureester und einem Styrol. In geringerer Menge können auch Einheiten zusätzlicher Monomerer, wie Acrylsäure, Acrylsäureester, Acryl- oder Methacrylnitril, Acryl- oder Methacrylamid oder Vinylheterocyclen enthalten sein. Als Methacrylsäureester werden Alkylester mit vorzugsweise 1 bis 10, insbesondere 1 bis 7 Kohlenstoffatomen, in der Alkylgruppe eingesetzt. Das Styrol kann ein o-, m- oder p-Vinyltoluol, ein Vinylethylbenzol, das α-Methyl- oder α-Chlorstyrol, ein o-, m- oder p-Chlorstyrol, ein Vinylanisol oder dgl. sein. Das unsubstituierte Styrol wird im allgemeinen bevorzugt. Der Mengenanteil an Styroleinheiten liegt im Bereich von 40 bis 65, vorzugsweise von 45 bis 55 Gew.-%; der des Methacrylsäureesters bei 5 bis 40, vorzugsweise zwischen 5 und 25 Gew.-%. Die Methacrylsäureeinheiten sollten in solcher Menge vorliegen, daß die Säurezahl des Polymeren im Bereich von 110 bis 280, vorzugsweise von 125 bis 260 liegt. Besonders der Anteil der Styrolverbindung muß in dem angegebenen Bereich liegen, um eine gute Lötstabilität zu erreichen. Der Mengenanteil des Polymeren im Gemisch beträgt im allgemeinen 15 bis 50, vorzugsweise 20 bis 40 Gew.-%.

Als mineralisches Pigment sind Silikate oder Kieselsäuren geeignet. Sie sollten zu einer solchen Teilchengröße vermahlen sein, daß mindestens 90 % der Teilchen einen Durchmesser von 5/um oder darunter haben. Dadurch erhält die Lötmaske eine glatte Oberfläche. Diese silikatischen Mineralien enthalten praktisch alle chemisch gebundenes Wasser in Form von OH-Gruppen am Silicium.

Diese OH-Gruppen sind wichtig; sie erlauben eine für die mechanischen Eigenschaften der Maske günstige Quervernetzung mit den weiter unten beschriebenen Epoxiden. Beispielsweise können eingesetzt werden: Kieselerden, Feldspate, Amphibole, Serpentin, Zeolite, Bimse und Phonolithe. Der SiO₂-Gehalt liegt dabei meist oberhalb 60 %. Als Gegenionen, die im Kristallverband enthalten sind, fungieren vorteilhaft Aluminium, Erdalkali- und Alkalimetalle. Der Mengenanteil des Pigments beträgt allgemein etwa 20 bis 50, vorzugsweise 25 bis 40 Gew.-%.

Als durch Strahlung aktivierbare Polymerisationsinitiatoren können zahlreiche Substanzen Verwendung finden. Beispiele sind Benzoine, Benzoinether, Mehrkernchinone, wie 2-Ethylanthrachinon, Acridinderivate, wie 9-Phenylacridin oder Benzacridine, Phenazinderivate, wie 9,10-Dimethylbenz(a)phenazin, Chinoxalin- oder Chinolin- derivate, wie 2,3-Bis-(4-methoxyphenyl )chinoxalin oder 2-Styrylchinolin, Chinazolinverbindungen oder Acylphosphinoxidverbindungen. Photoinitiatoren dieser Art sind in den DE-C 20 27 467, 20 39 861, der DE-A 37 28 168, der EP-B 11 786 und der EP-A 220 589 beschrieben. Außerdem können z. B. Hydrazone, Mercaptoverbindungen, Pyrylium- oder Thiopyryliumsalze, Xanthone, Thioxanthone, Benzochinone, Acetophenone, Benzophenone, synergistische Mischungen mit Ketonen oder Hydroxyketonen und Farbstoff-Redoxsysteme eingesetzt werden. Besonders bevorzugt werden Photoinitiatoren, die durch Licht spaltbare Trihalogenmethylgruppen aufweisen, wobei insbesondere entsprechende Verbindungen aus der Triazin- oder Thiazolinreihe erwähnt sein sollen. Solche Verbindungen sind in den DE-A 27 18 259, 33 33 450 und 33 37 024 beschrieben. Ein bevorzugtes Beispiel ist 2-(4-Methoxystyryl)4,6-bis-trichlormethyl-s-triazin.

Die Photoinitiatoren werden im allgemeinen in Mengenanteilen von 0,1 bis 15, vorzugsweise von 0,5 bis 10 Gew.-%, bezogen auf die nichtflüchtigen Bestandteile des Gemischs, zugesetzt.

Das erfindungsgemäße Gemisch enthält ferner zwei- oder mehrwertige Epoxyverbindungen. Als Beispiele sind insbesondere Bisglycidylether von zweiwertigen Alkoholen und Phenolen, z. B. von Bisphenol A, von Polyethylenglykol- und Polypropylenglykolethern des Bisphenols A, von Butan-1,4-diol, Hexan-1,6-diol, Polyethylenglykol, Polypropylenglykol oder Polytetrahydrofuran geeignet.

Auch Bisglycidylether von dreiwertigen Alkoholen, z. B. von Glycerin, können verwendet werden. Die Epoxide werden dem Gemisch gewöhnlich in einer Menge von etwa 10 bis 30, vorzugsweise 12 bis 25 Gew.-%, bezogen auf die nichtflüchtigen Bestandteile des Gemisches, zugesetzt.

Bevorzugt werden Bisepoxide der allgemeinen Formel 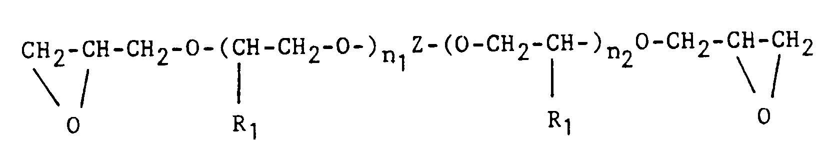 verwendet, worin
- Z: eine Alkylen- oder Hydroxyalkylengruppe mit 2 bis 6 Kohlenstoffatomen oder die Gruppe 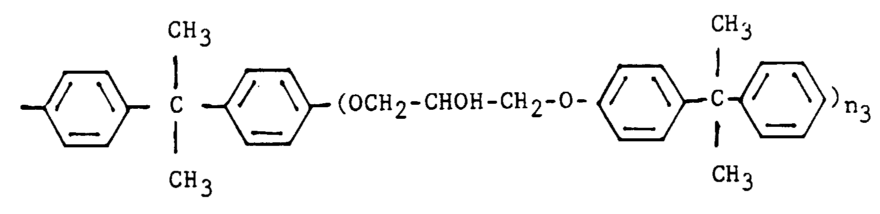
- R₁: ein Wasserstoffatom oder eine Methylgruppe,
- n₁ und n₂: Zahlen von 0 bis 10, vorzugsweise von 0 bis 5, und
- n₃: 0 oder eine Zahl von 1 bis 4, vorzugsweise u oder 1,
bedeuten.

Als tris- und polyfunktionelle Epoxide eignen sich besonders epoxydierte Phenol-Formaldehydharze mit Kettengliedern der allgemeinen Formel: 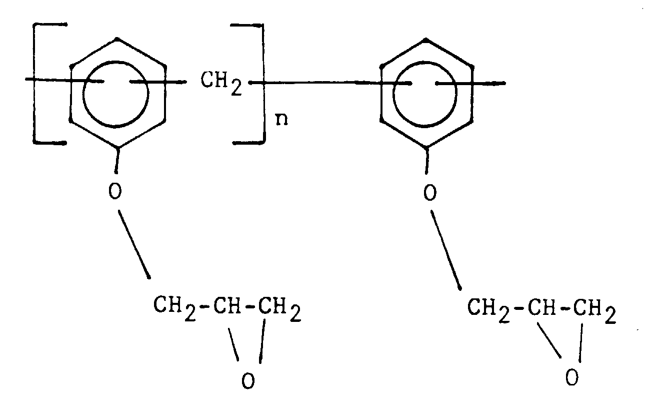 worin n eine ganze Zahl ist, die mindestens den Wert 2 hat.

Als weiteren wesentlichen Bestandteil enthält das Gemisch einen Härter oder Additionsinitiator für Epoxygruppen. Der Härter ist bevorzugt eine Stickstoffbase, z. B. Triethylamin, 1,4-Diazabicyclo[2.2.2]octan (Dabco), Dibutylamin, höher alkylierte Mono-, Di- und Triamine auf aliphatischer Basis, ferner aliphatisch-aromatische Amine wie z. B. Dimethylanilin. Die tertiären, insbesondere aliphatischen Amine werden bevorzugt. Ganz besonders bevorzugt wird das Diazabicyclooctan. Die Menge der Base liegt im allgemeinen zwischen 0,15 und 1,5, vorzugsweise zwischen 0,2 und 1,0 Gew.-%.

Vorzugsweise enthält das Gemisch mindestens einen Farbstoff, um die entwickelte Resistschablone besser sichtbar zu machen. Dabei wird mit Vorteil eine Kombination von mindestens zwei Farbstoffen verwendet, von denen der eine bei Bestrahlung seine Farbe ändert und bei Temperaturen oberhalb 200 °C zerstört, d. h. farblos wird. Der andere Farbstoff soll sowohl die Bestrahlung als auch Temperaturen oberhalb 200 °C ohne Veränderung überstehen. Er soll die Lötstopmaske während des Lötens und danach deutlich sichtbar machen. Hierfür geeignete Farbstoffe sind in der DE-A 3 114 931 beschrieben.

Das Gemisch kann gegebenenfalls eine Reihe weiterer üblicher Zusätze enthalten, z. B. Inhibitoren zur Verhinderung der thermischen Polymerisation der Monomeren, Wasserstoffdonatoren, sensitometrische Regler, Pigmente, Weichmacher und Thixotropiermittel, insbesondere mineralische Pigmente, wie SiO₂, oder organische Polymere, wie Polyacrylamide. Thixotropiermittel sind z. B. beim Antrag durch Siebdruck von Vorteil.

Das erfindungsgemäße Gemisch ist in der verarbeitungsfertigen Form nur begrenzt haltbar; daher werden die Einzelkomponenten zweckmäßig in mindestens zwei Gebinden - "Zweikomponentenlack" - getrennt aufbewahrt. Normalerweise wird so verfahren, daß alle Komponenten, mit Ausnahme der Epoxidverbindung, in einer Hauptmischung vorliegen, der kurz vor der Verarbeitung das Epoxid beigemischt wird. Man kann aber auch z. B. den Härtungsinitiator als getrennte Komponente halten. Auch Farbstoffe, mineralischer Feststoff und andere Zusatzstoffe können in getrennten Mischkomponenten vorliegen, so daß gegebenenfalls auch ein Dreikomponentensystem rezepturiert weraen kann. Wichtig ist, daß die Teilgemische vor dem Mischprozeß eine hinreichend lange Haltbarkeit (ca. 6 bis 12 Monate) besitzen.

Die Verarbeitung des erfindungsgemäßen Gemischs erfolgt in bekannter Weise, z. B. im Siebantrag. Das gelöste bzw. dispergierte Gemisch wird z. B. durch ein in einem Metallrahmen gespanntes Siebgewebe von 37 bis 55 Maschen je cm mit einer Rakel auf das Leiterplattenobjekt aufgebracht. Eine andere Möglichkeit ist die Vorhangbeschichtung. Mit Hilfe einer handelsüblichen Vorhanggießmaschine wird ein kontinuierlich vertikal laufender Flüssigfilm erzeugt. Mittels eines Förderbandes wird die Leiterplatte unter diesem Film durchgeführt und damit beschichtet. Das Gemisch kann schließlich auch über eine elektrostatische Sprühbeschichtung aufgebracht werden. In einer geschlossenen Kabine wird die Lösung an einem Sprühkopf in feinste Tröpfchen zerteilt, diese durch Hochspannung elektrostatisch aufgeladen und auf der Leiterplatte abgeschieden. Auch im Tauchziehverfahren und durch Walzenantrag lassen sich die Mischungen verarbeiten.

Die nach einem der geschilderten Verfahren verarbeiteten Beschichtungsgemische werden durch Trocknen im Umlufttrockenschrank oder unter einem IR-Trockner vom Lösemittel befreit. Die so beschichtete Leiterplatte wird dann durch eine Vorlage belichtet, die die Teile der Platte vor der Bestrahlung schützt, die für den Lötvorgang freibleiben müssen.

Als aktinische Strahlung, gegenüber der das erfindungsgemäße Gemisch empfindlich ist, kommt jede elektromagnetische Strahlung in Betracht, deren Energie zur Anregung eines geeigneten Polymerisationsinitiators ausreicht. Geeignet ist insbesondere sichtbares und ultraviolettes Licht, Röntgen-, γ- und Elektronenstrahlung. Auch Laserstrahlung im sichtbaren und UV-Bereich kann verwendet werden. Bevorzugt wird kurzwelliges sichtbares und nahes UV-Licht.

Entwickelt werden die Schichten in bekannter Weise. Als Entwickler sind wäßrige, vorzugsweise wäßrig-alkalische Lösungen, z. B. von Alkaliphosphaten, -carbonaten oder -silikaten, geeignet, denen gegebenenfalls kleine Mengen, z. B. bis zu 10 Gew.-% an mit Wasser mischbaren organischen Lösemitteln oder Netzmitteln zugesetzt werden können.

Fertig entwickelte Lötmasken werden vor dem Lötprozeß einer Temperaturbehandlung unterzogen. Dabei reagieren die Carboxylgruppen des Bindemittels mit dem mehrfunktionellen Epoxid zu einem interpenetrierenden Netzwerk. Integrierender Bestandteil dieses Netzwerkes ist auch der mineralische Feststoff, dessen silikatische OH-Gruppen durch Wasserstoffbrücken- und Kovalenzbindungen zur Härtung der Maske wesentlich beitragen.

Insgesamt werden durch die thermische Nachbehandlung die guten mechanischen, thermischen und chemischen Eigenschaften der Lötstopmasken bewirkt. Diese thermische Behandlung erfolgt im allgemeinen zwischen 80 °C und 150 °C, bei ungefähren Behandlungszeiten von 10 bis 60 Minuten. Die lötbereite Platte kann dann mit elektronischen Bauelementen in bekannter Weise bestückt werden.

Die Leitungsseite der Platte wird anschließend üblicherweise mit einem passenden, handelsüblichen Flußmittel behandelt und über eine handelsübliche Schwall-Lötmaschine der Schwall-Lötung unterworfen. Als Lötmittel dienen bekannte eutektische Gemische, die Löttemperaturen von etwa 230 bis 260 °C gestatten. Ein bekanntes Gemisch enthält beispielsweise 63 Gew.-% Zinn und 37 Gew.-% Blei. Besonders bei Verfahren, bei denen doppelseitige, durchkontaktierte Leiterplatten durch Eintauchen in flüssige Metallbäder gelötet werden, lassen sich die erfindungsgemäß hergestellten Lötstopmasken mit Erfolg einsetzen.

Die erfindungsgemäßen Gemische ergeben Lötstopresistschichten, die sich durch hohe Flexibilität und mechanische Festigkeit im unbelichteten und belichteten Zustand und durch eine hohe Temperaturresistenz im belichteten und nachgehärteten Zustand auszeichnen. Die photopolymerisierbaren Schichten weisen in Kombination mit den bevorzugten Photoinitiatoren eine hohe Lichtempfindlichkeit auf und ergeben auch bei hoher Schichtdicke eine gute Durchhärtung bzw. Durchvernetzung. Die belichteten Schichten lassen sich auch bei Schichtdicken oberhalb 100 µm einwandfrei und vollständig mit wäßrig-alkalischen Lösungen entwickeln.

Die belichteten und entwickelten Schichten lassen sich ohne übermäßige Beeinträchtigung der Flexibilität der Maske oder ihrer Haftung auf der Unterlage und ohne Veränderung der Lage und Dimensionen der durch Entwicklung freigelegten Bereiche thermisch härten. Die gehärteten Masken sind gegenüber atmosphärischen, thermischen und chemischen Einflüssen über längere Zeiträume beständig. Nach dem Belichten der Resistschicht wird ein kontrastreiches Bild in der Schicht erhalten. Die aus den erfindungsgemäßen Gemischen erhaltenen Lötstopmasken eignen sich in besonderem Maße dazu, empfindliche elektronische Leiterstrukturen vor atmosphärischen Angriffen wirksam und dauerhaft zu schützen.

Die folgenden Beispiele erläutern einzelne Ausführungsformen des erfindungsgemäßen Gemisches. Wenn nichts anderes angegeben ist, sind Prozentzahlen und Mengenverhältnisse in Gewichtseinheiten zu verstehen. Gewichtsteile (Gt) und Volumenteile (Vt) stehen im Verhältnis von g zu ml.

### Beispiel 1

### Herstellung einer verarbeitungsfertigen Lötstopmaske

a) 320 Gt Styrol, 150 Gt Methacrylsäure, 30 Gt n-Hexylmethacrylat und 15 Gt 2,2-Azo-bis-isobuttersäurenitril wurden unter Rühren in 450 Gt 3-Methoxy-butanol-1 gelöst. 1/3 dieser Lösung wurde in einem Rundkolben unter Rühren und Hindurchleiten von Stickstoff auf 90 °C erwärmt. Die einsetzende exotherme Polymerisation wurde durch äußere Kühlung bei 90 °C bis maximal 100 °C gehalten. Nach Abklingen der Hauptreaktion wurden die zurückbehaltenen 2/3 der Lösung innerhalb 1 1/2 Stunden gleichmäßig zudosiert und anschließend die Reaktionslösung noch 12 bis 14 Stunden bei 90 °C gehalten. Die Polymerlösung war nach Abkühlen auf Zimmertemperatur gebrauchsfertig.
   Die reduzierte spezifische Viskosität des Produkts betrug 0,185 dl/g (gemessen an einer 1 %igen Lösung in Dimethylformamid bei 25 °C).
b) In einem zylindrischen Gefäß wurden in 123,9 Gt 3-Methoxy-butanol-1
   - 112,5 Gt: Pentaerythrit-triacrylat,
   - 128,9 Gt: Trimethylolpropan-triacrylat,
   - 27,5 Gt: 9-Phenylacridin,
   - 12,4 Gt: Neozapongrün,
   - 1,2 Gt: eines blauen Azofarbstoffs, erhalten durch Kuppeln von 2,4-Dinitro-6-chlor-benzoldiazoniumsalz mit 2-Methoxy-5-acetylamino-N,N-diethylanilin und
   - 2,5 Gt: Triethylendiamin
   mit einem hochtourigen Schnellrührer in Lösung gebracht. Dann wurden im Verlauf von 30 Minuten 396,7 Gt eines silikatischen Pigments, das ein natürliches Agglomerat von korpuskularem Quarz und laminarem Kaolinit ist, in die gerührte Lösung eingestreut. Es enthält über 80 % SiO₂ und ca. 11 % Al₂O₃; ca. 90 Gew.-% der Teilchen haben eine Korngröße unterhalb 5µm (Sillitin). Dieser Suspension wurden anschließend 694,2 Gt der unter a) beschriebenen Polymerlösung zugesetzt. Der nun mit allen Komponenten versehene Ansatz wurde mit Hilfe des Mischers gut homogenisiert (1.200 U/min), wobei darauf geachtet wurde, daß die Temperatur des Ansatzes nicht über 50 bis 55 °C anstieg.
   Der viskose Lack wurde zur weiteren Homogenisierung in einer Glaskugelmühle vermahlen und dann durch ein 160 µm V2A-Gewebe-Druckfilter filtriert und abgefüllt. Diese Mischung wurde, soweit erforderlich, mit Methoxybutanol auf einen Feststoffgehalt von 68,6 Gew.-% verdünnt und im Folgenden als Komponente A bezeichnet.
c) In einem zylindrischen Gefäß wurden 252 Gt eines epoxydierten Phenol-Formaldehyd-Harzes mit dem Epoxid-Äquivalentgewicht 172 bis 179 in 148 Gt 3-Methoxybutanol mittels eines Ankerrührers gelöst. Nach 15 Minuten Rührzeit lag eine klare Lösung mit 63 % Feststoffgehalt vor. Diese Lösung wurde im Folgenden als Komponente B bezeichnet.
d) 100 Gt der Komponente A wurden mit 22,3 Gt der Komponente B mit einem passenden Rührer intensiv gemischt. Damit war die Lötstoplösung zum Gebrauch, also zum Antrag auf eine Leiterplatte nach einem der oben erwähnten Verfahren, fertig. Der Feststoffgehalt betrug 67,5 %.
e) Eine 24 x 36 cm große Platte aus Epoxidharz-Glasgewebe mit einem beidseitig aufgebrachten Schaltbild aus 0,2 bis 1,5 mm breiten und 50 bis 90µm dicken Kupferbahnen und durchkontaktierten Bohrungen wurde mit der unter d) beschriebenen Lösung mittels einer halbautomatischen Siebdruckmaschine (Alfra-Plan 50/70) vollflächig beschichtet. Zur Lackübertragung wurde ein vollflächig offenes Polyestersieb mit 43 Maschen je cm verwendet; die Gummirakel mit einer Härte von 70 Shore war an der Druckkante leicht abgerundet, und der Antragswinkel betrug 15°. Auf diese Weise ließen sich blasen- und farbschattenfreie Beschichtungen mit einer Flankenabdeckung von 15 bis 20µm erzielen. Die so beschichtete Leiterplatte wurde 5 Minuten bei Raumtemperatur belassen und anschließend 7 Minuten in einem Umlufttrockenschrank bei 80 °C getrocknet. Nach dem Abühlen auf Raumtemperatur wurde die beschichtete Leiterplatte durch eine Filmvorlage bildmäßig belichtet.
   Die Belichtungszeit an einer eisendotierten Quecksilber-Hochdrucklampe betrug 25 s; ein zu Kontrollzwecken auf den Lötstoplack aufgelegter Halbton-Stufenkeil (Hoechst BK 02) zeigte nach dem Entwickeln sieben gedeckte und eine teilgedeckte Keilstufe. Entwickelt wurde in einer Durchlaufsprühanlage mit 1 %iger wäßriger Sodalösung bei 30 °C mit 1,2 bar Sprühdruck. Die Entwicklungszeit betrug 90 s; die unbelichteten Schichtbereiche waren bereits nach 2/3 der Entwicklerstrecke frei entwickelt.
   Nach Waschen mit Wasser wurde die entwickelte Platte in einem Warmluftdurchlauftrockner getrocknet und anschließend in einem Umlufttrockenofen 1 Stunde bei 150 °C getempert. Die nun vollständig ausgehärtete Platine wurde schwallgelötet, eine zweite Platine, die in gleicher Weise hergestellt worden war, wurde heißverzinnt.
   Das Löten wurde auf einer Schwall-Lötmaschine durchgeführt. Dazu wurde die Platte über einen vorgeschalteten Schaumfluxer (Alphagrillo TL 33) geführt, vorgetrocknet und über das aus eutektischer Blei/Zinnlegierung bestehende flüssige Lot gefahren. Die Geschwindigkeit betrug 0,9 m je Minute, die Lottemperatur 260 °C. Zwecks Beseitigung der noch anhaftenden Flußmittelreste wurde 3 Minuten mit einer Mischung aus 65 % Trichlortrifluorethan und 35 % 2-Propanol und dann 3 Minuten mit reinem Trichlortrifluorethan gewaschen. Das Lötergebnis der so verarbeiteten Leiterplatte war hervorragend: Die Lötstopmaske zeigte keinerlei Angriff, und die Oberfläche war völlig frei von Blei/Zinn-Rückständen, während die freigelegten Kupferflächen einwandfreie Lotbenetzung aufwiesen.
   Mit der zweiten Platine wurde eine Heißluftverzinnung ("Hot-Air-Levelling") durchgeführt. Dazu wurde die Platine mittels Gummiwalzen mit einem wasserlöslichen Flußmittel (Robertson SM 287) benetzt und durch Eintauchen in flüssiges Lot und anschließendes Abblasen mit heißer Luft verzinnt. Die Lottemperatur betrug 250 °C, die Temperatur der an den beiden Luftmessern mit hohem Druck austretenden Luft 260 °C, die Eintauchzeit war auf 5 s eingestellt. Nach Waschen mit Wasser und Trocknen zeigte auch diese Platte eine völlig einwandfreie Oberfläche.
f) Wird der unter d) beschriebene, für den Siebantrag direkt verwendbare Lack für ein anderes Antragsverfahren verwendet, so ist der Feststoffgehalt von 67,5 % zu hoch. Wird die Maske durch einen vertikal fallenden Vorhang aus dem Längsspalt einer Vorhanggießmaschine auf die Leiterplatte angetragen, muß der Feststoff durch Verdünnen mit Methoxybutanol aur ca. 58 bew.-% gesenkt werden. Ähnliche Konzentrationen sind erforderlich, wenn die Maske im Hochspannungsfeld mittels eines rotierenden Sprühkopfes auf die Leiterplatte gesprüht wird. Auch diese Techniken führen zu einer sehr guten Leiterbahnumhüllung durch die Maske, die die Platte absolut porenfrei und in gleichmäßiger Stärke abdeckt. Die Verarbeitung analog e) führt zu demselben guten Ergebnis: fehlerlos freientwickelte Kupferpartien, völlig einwandfreie Oberflächen nach beiden unter e) beschriebenen Lötprozessen.

### Beispiele 2 bis 10

In der folgenden Tabelle 1 sind 10 Lösungen von Polymeren angegeben, die in Analogie zum Polymeren des Beispiels 1a hergestellt wurden. Die Mengen sind in Gewichtsprozenten angegeben.

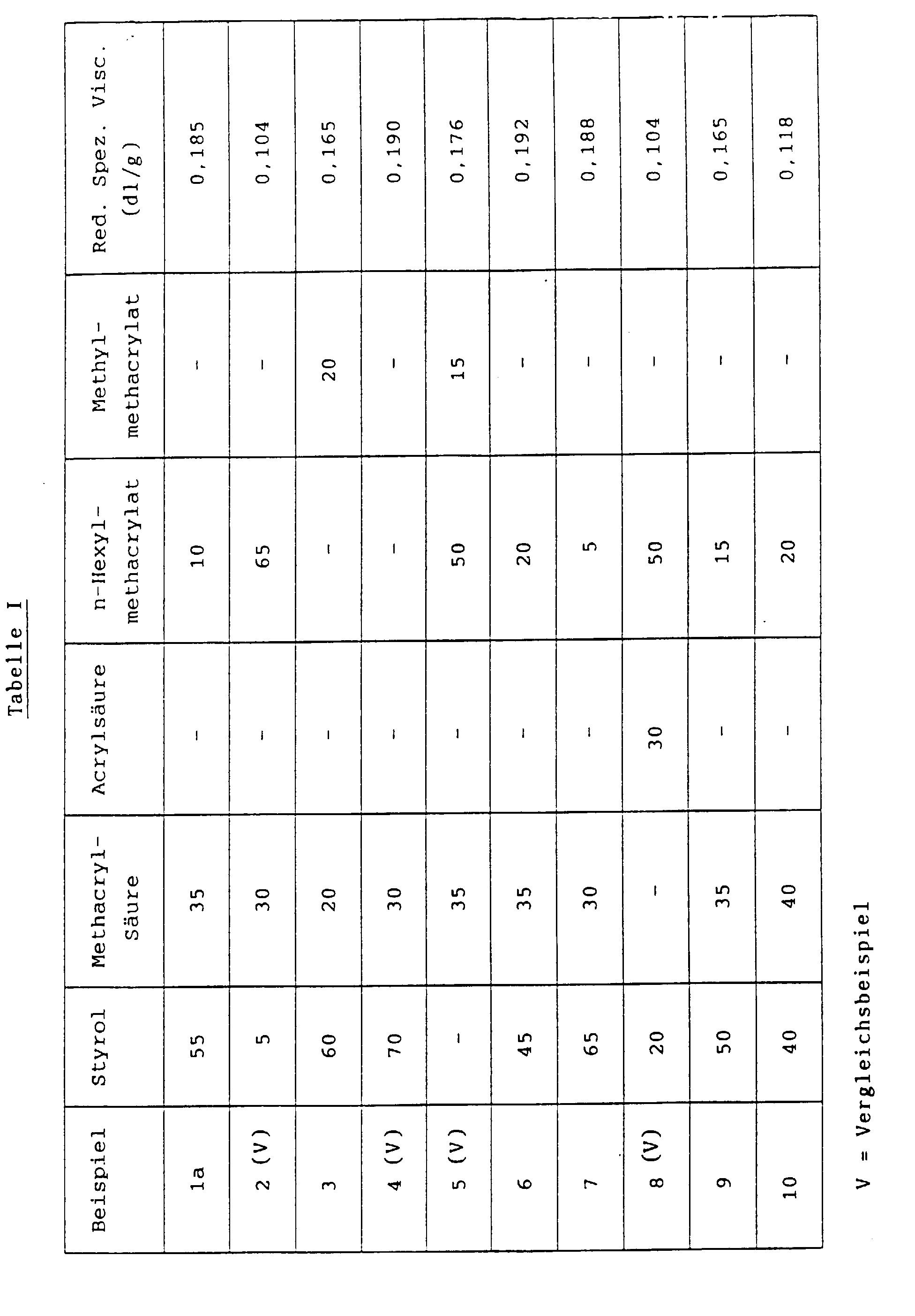

### Beispiele 11 bis 24

In der folgenden Tabelle II sind 14 Beispiele summiert, die sich in der technischen Durchführung nicht von Beispiel 1 unterscheiden, jedoch rezeptuelle Unterschiede aufweisen. Dadurch bedingte Eigenschaftsvariationen der Resists sind in der Tabelle II stichwortartig notiert.

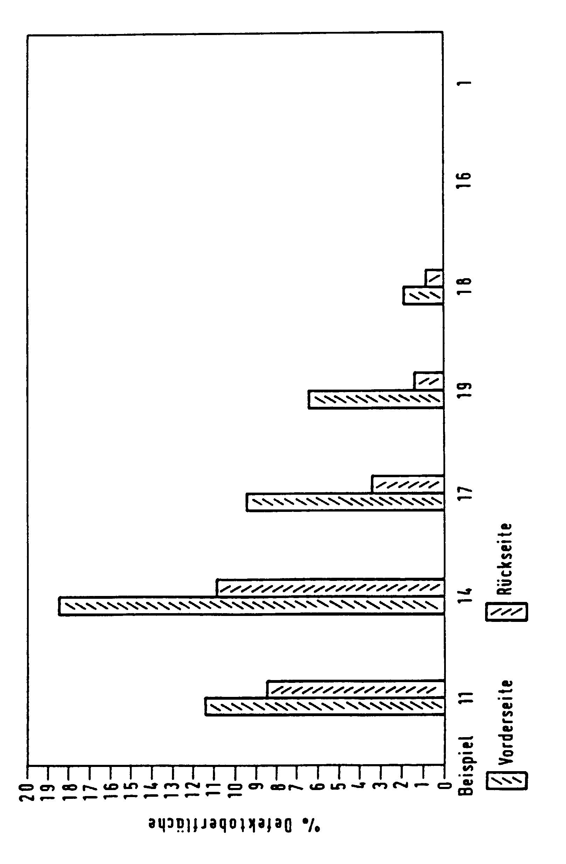

Das spezielle Verhalten der Versuchsplatinen im Heißverzinnungsprozeß, wie unter le beschrieben, ist in der Zeichnung graphisch dargestellt. Dort wird der geschädigte Anteil der Oberfläche (Vorder- und Rückseite) einzelner Platinen in % angegeben. Die Oberflächenschädigung bezieht sich vor allem auf Lotrückstände in Form von Kügelchen, spinnwebenartigen Fäden und Netzen.

Die in Beispiel 1 erwähnten Farbstoffe wurden in den gleichen Mengen wie dort zugesetzt. Die Gewichtsteile der Polymeren beziehen sich auf 50 %ige Lösungen in Methoxybutanol (entsprechend der in Beispiel la angegebenen Konzentration), die Gewichtsteile der übrigen Komponenten auf lösemittelfreie Feststoffe.

Der Feststoffgehalt der Mischungen in den Beispielen 11 bis 24 wurde analog Beispiel 1 durch Zugabe von Methoxybutanol auf eine Viskosität von 8,5 bis 50 dPa·s gebracht. Das wird in der Regel, wieder in Analogie zu Beispiel 1, mit Feststoffgehalten von 58 bis 68 % erreicht.

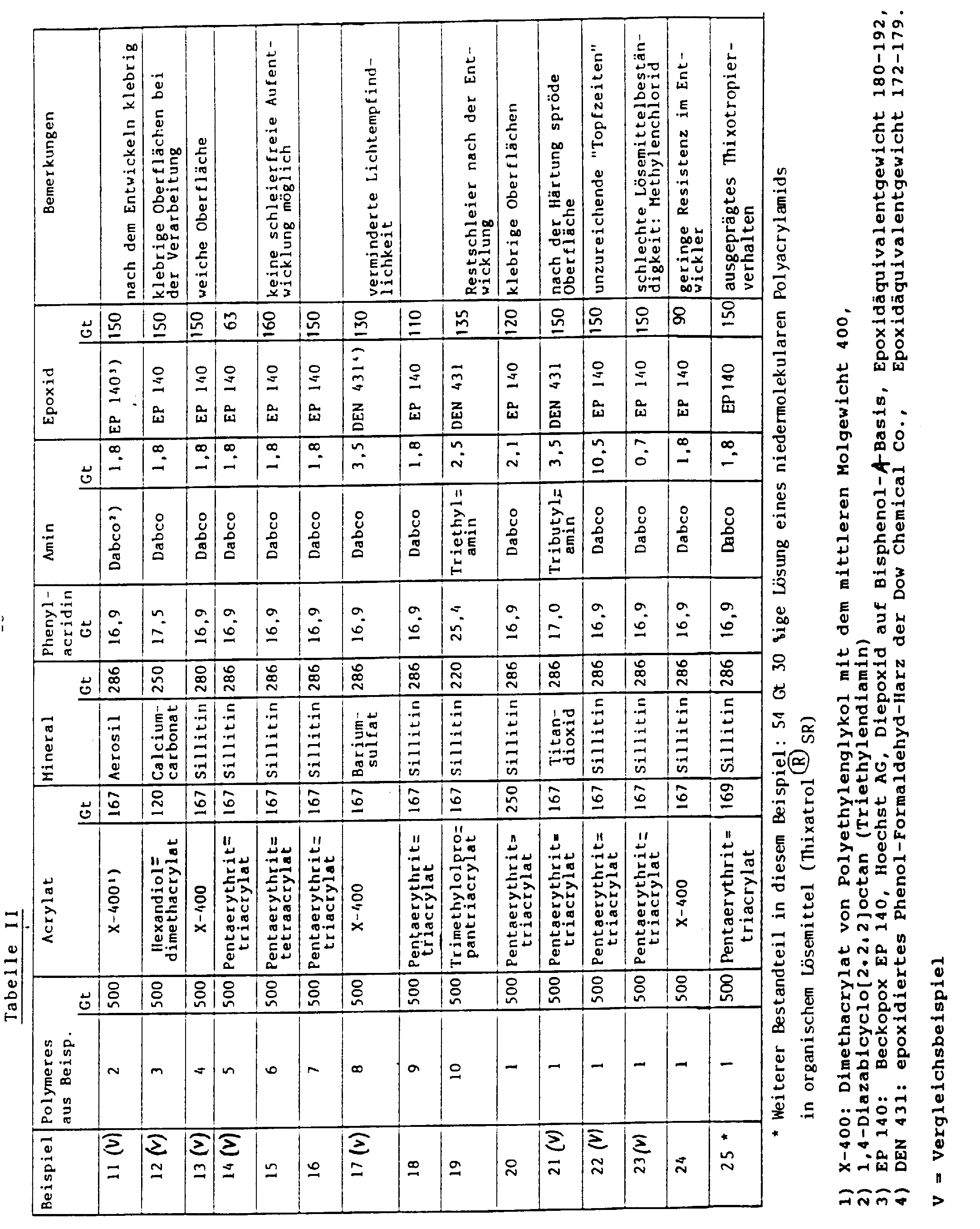

## Patentansprüche

1. Durch Strahlung polymerisierbares Gemisch, enthaltend
a) eine Verbindung mit mindestens zwei endständigen ethylenisch ungesättigten Gruppen, die durch radikalisch initiierte Additionskettenpolymerisation ein vernetztes Polymerisat zu bilden vermag,
b) ein polymeres Bindemittel, das aus Einheiten
1. von Methacrylsäure,
2. eines Methacrylsäureesters,
3. eines Styrols, bestehend aus Styrol, o-, m- oder p-Vinyltoluol, einem Vinylethylbenzol, einem α-Methylstyrol, einem α-Chlorstyrol, einem o-, m- oder p-Chlorstyrol oder einem Vinylanisol, und
4. ggf. eines Monomers, bestehend aus Acrylsäure, einem Acrylsäureester, Acrylnitril, Methacrylnitril, Acrylamid, Methacrylamid oder einer heterozyklischen Vinylverbindung,
besteht, wobei
das Styrol in einer Menge von 40 - 65 Gew.% und der Methacrylsäureester in einer Menge von 5 - 40 Gew.%, bezogen auf das Gewicht des polymeren Bindemittels, und die Methacrylsäure in solcher Menge enthalten ist, daß das polymere Bindemittel eine Säurezahl von 110 - 280 besitzt.
c) 20 - 50% feinteiliges mineralisches Pigment auf Silikat- bzw. Kieselsäurebasis,
d) 0,1 - 15% eines durch Stahlung aktivierbaren Polymerisationsinitiators,
e) 10 - 30% einer Verbindung mit mindestens zwei Epoxygruppen im Molekül und
f) 0,2 - 1,0% eines durch Wärme aktivierbaren Polyadditionsinitiators für Epoxygruppen,
wobei sich die Prozentzahlen der Bestandteile b), c), d), e) und f) auf den Gesamtgehalt an nicht flüchtigen Bestandteilen in dem Gemisch beziehen.

2. Durch Strahlung polymerisierbares Gemisch nach Anspruch 1, **dadurch gekennzeichnet,** daß es ferner einen Farbstoff enthält.

3. Durch Strahlung polymerisierbares Gemisch nach einem der Ansprüche 1 oder 2, **dadurch gekennzeichnet**, daß der Polyadditionsinitiator ein organisches Amin ist.

4. Durch Strahlung polymerisierbares Gemisch nach einem der Ansprüche 1 bis 3, **dadurch gekennzeichnet,** daß das Bindemittel Einheiten eines Methacrylsäurealkylesters mit 1 bis 10 Kohlenstoffatomen in der Alkylgruppe enthält.

5. Durch Strahlung polymerisierbares Gemisch nach einem der Ansprüche 1 bis 4, **dadurch gekennzeichnet**, daß es 10 bis 35 Gew. % polymerisierbare Verbindung a), 15 bis 50 Gew.% polymeres Bindemittel b), 20 bis 50 Gew.% Pigment c), 0,1 bis 10 Gew.% Polymerisationsinitiator d), 10 bis 30 Gew.% Epoxyverbindung e) und 0,2 bis 1,0 Gew. % Polyadditionsinitiator f), bezogen auf die Gesamtmenge an nicht flüchtigen Bestandteilen, enthält.

6. Durch Strahlung polymerisierbares Gemisch nach einem der Ansprüche 1 bis 6, **dadurch gekennzeichnet**, daß das polymere Bindemittel 5 bis 25 Gew.% Methacrylsäureester enthält.

7. Durch Strahlung polymerisierbares Gemisch nach einem der Ansprüche 1 bis 6, **dadurch gekennzeichnet**, daß es 25 bis 40 Gew.% Pigment c) enthält.

8. Verfahren zur Herstellung einer Lötstopmaske, **dadurch gekennzeichnet**, daß man eine Lösung bzw. Dispersion eines Gemisches gemäß einem der Ansprüche 1 bis 7 auf die Oberfläche einer gedruckten Schaltung aufbringt und trocknet, die erhaltene Schicht bildmäßig mit aktinischer Strahlung unter Aussparung der Lötaugen bestrahlt, die unbestrahlten Schichtbereiche mit einem Entwickler auswäscht und die erhaltene Lötmaske auf erhöhte Temperatur erwärmt.

9. Verfahren nach Anspruch 8, **dadurch gekennzeichnet**, daß man die Lötmaske 10 bis 60 Minuten auf eine Temperatur im Bereich von 80 bis 150°C erwärmt.

## Claims

1. Radiation-polymerizable mixture containing
a) a compound having at least two terminal ethylenically unsaturated groups capable of forming a crosslinked polymer by free radical-initiated addition chain polymerization,
b) a polymeric binder which consists of units
1. of methacrylic acid,
2. of a methacrylic acid ester,
3. of a styrene, consisting of styrene or o-, m- or p-vinyltoluene, a vinylethylbenzene, an α-methylstyrene, an α-chlorostyrene, an o-, m- or p-chlorostyrene or a vinylanisole, and
4. optionally of a monomer consisting of acrylic acid, an acrylic acid ester, acrylonitrile, methacrylonitrile, acrylamide, methacrylamide or a heterocyclic vinyl compound,
the styrene being present in an amount of 40 - 65% by weight and the methacrylic acid ester in an amount of 5 - 40% by weight, based on the weight of the polymeric binder, and the methacrylic acid being present in an amount such that the polymeric binder has an acid number of 110 - 280,
c) 20 - 50% of a finely divided silicate- or silica-based mineral pigment,
d) 0.1 - 15% of a radiation-activatable polymerization initiator,
e) 10 - 30% of a compound having at least two epoxy groups in the molecule and
f) 0.2 - 1.0% of a heat-activatable polyaddition initiator for epoxy groups, the percentages of the components b), c), d), e) and
f) being based on the total content of nonvolatile components in the mixture.

2. Radiation-polymerizable mixture according to Claim 1, characterized in that it furthermore contains a dye.

3. Radiation-polymerizable mixture according to either of Claims 1 or 2, characterized in that the polyaddition initiator is an organic amine.

4. Radiation-polymerizable mixture according to any of Claims 1 to 3, characterized in that the binder contains units of an alkyl methacrylate having 1 to 10 carbon atoms in the alkyl group.

5. Radiation-polymerizable mixture according to any of Claims 1 to 4, characterized in that it contains 10 to 35% by weight of polymerization compound a), 15 to 50% by weight of polymeric binder b), 20 to 50% by weight of pigment c), 0.1 to 10% by weight of polymerization initiator d), 10 to 30% by weight of epoxy compound e) and 0.2 to 1.0% by weight of polyaddition initiator f), based on the total amount of nonvolatile components.

6. Radiation-polymerizable mixture according to any of Claims 1 to 6, characterized in that the polymeric binder contains 5 to 25% by weight of methacrylic acid ester.

7. Radiation-polymerizable mixture according to any of Claims 1 to 6, characterized in that it contains 25 to 40% by weight of pigment c).

8. Process for the production of a soldering mask, characterized in that a solution or dispersion of a mixture according to any of Claims 1 to 7 is applied to the surface of a printed circuit and dried, the layer obtained is exposed imagewise to actinic radiation, with the exception of the soldering eyes, the unexposed parts of the layer are washed out with a developer and the soldering mask obtained is heated to an elevated temperature.

9. Process according to Claim 8, characterized in that the soldering mask is heated to a temperature in the range from 80 to 150°C for 10 to 60 minutes.

## Revendications

1. Mélange polymérisable par rayonnements, contenant
a) un composé comportant au moins deux groupes terminaux éthyléniquement insaturés, lequel est capable de former un polymérisat réticulé au moyen d'une polymérisation d'addition en chaîne à initiation radicalaire.
b) un liant polymérique, composé de motifs
1. d'acide méthacrylique,
2. d'un ester d'acide méthacrylique,
3. d'un styrène, constitué de styrène, d'un o-, m- ou p-vinyltoluène, d'un vinyléthylbenzène, d'un α-méthylstyrène, d'un α-chlorostyrène, d'un o-, m- ou p-chlorostyrène ou d'un vinylanisol, et
4. le cas échéant d'un monomère, constitué d'acide acrylique, d'un ester d'acide acrylique, d'acrylonitrile, de méthacrylo-nitrile, d' acrylamide, de méthacrylamide ou d'un composé vinylique hétérocyclique,
où
le styrène est contenu en une quantité de 40 à 65 % en poids et l'ester d'acide méthacrylique est contenu en une quantité de 5 - 40 % en poids par rapport au poids du liant polymérique, et l'acide méthacrylique est contenu en une quantité telle que le liant polymérique présente un indice d'acidité de 110 - 280.
c) 20 à 50 % de pigment minéral finement divisé à base de silicate ou d'acide silicique,
d) 0,1 à 15 % d'un initiateur de polymérisation activable par radiation,
e) 10 - 30 % d'un composé comportant au moins deux groupes époxy dans la molécule et
f) 0,2 à 1,0 % d'un initiateur de polyaddition pour groupes époxy activable par chaleur,
où les pourcentages des constituants b), c), d), e) et f) se réfèrent à la teneur globale en constituants non volatils dans le mélange.

2. Mélange polymérisable par radiation selon la revendication 1,
caractérisé en ce qu'il
contient de plus un colorant.

3. Mélange polymérisable par radiation selon une des revendications 1 ou 2,
caractérisé en ce que
l'initiateur de polyaddition est une amine organique.

4. Mélange polymérisable par radiation selon une des revendications 1 à 3,
caractérisé en ce que
le liant contient des motifs d'un ester alkylique d'acide méthacrylique comportant 1 à 10 atomes de carbone dans le groupe alkyle.

5. Mélange polymérisable par radiation selon une des revendications 1 à 4,
caractérisé en ce qu'il
contient 10 à 35 % en poids du composé polymérisable a), 15 à 50 % en poids du liant polymérique b), 20 à 50 % en poids du pigment c), 0,1 à 10 % en poids de l'initiateur de polymérisation d), 10 à 30 % en poids du composé époxyde e) et 0,2 à 1,0 % en poids de l'initiateur de polyaddition f) par rapport à la quantité totale en constituant non volatils.

6. Mélange polymérisable par radiation selon une des revendications 1 à 5,
caractérisé en ce que
le liant polymérique contient 5 à 25 % en poids d'ester d'acide méthacrylique.

7. Mélange polymérisable par radiation selon une des revendications 1 à 6,
caractérisé en ce qu'il
contient 25 à 40 % en poids du pigment c).

8. Procédé de fabrication d'un masque pour soudage,
caractérisé en ce que
l'on dépose une solution ou une dispersion d'un mélange selon une des revendications 1 à 7 sur la surface d'un circuit imprimé et que l'on sèche celle-ci, que l'on transfère une image en insolant la couche obtenue à l'aide de rayonnements actiniques en épargnant les pastilles, que l'on élimine les régions non insolées à l'aide d'un révélateur et que l'on chauffe le masque pour soudage ainsi obtenu à une température plus élevée.

9. Procédé selon la revendication 8,
caractérisé en ce que l'on chauffe le masque pour soudage pendant 10 à 60 minutes à une température comprise entre 80 à 150 °C.
